# EUROPEAN PATENT SPECIFICATION

(11) **EP 3 411 722 B1**
(45) Date of publication and mention of the grant of the patent: **10.07.2019**
(21) Application number: 17702452.8
(22) Date of filing: 09.01.2017
(51) Int. Cl.: H01L 23/62, H02H 9/02, G01R 31/28, G01R 31/02

(54) **SHORT-RESISTANT OUTPUT PIN CIRCUITRY**
AUSGANGSPINSCHALTUNG MIT KURZSCHLUSSWIDERSTAND
CIRCUITS DE BROCHE DE SORTIE RÉSISTANTS AUX COURTS-CIRCUITS

(30) Priority: 01.02.2016 US 201615012723
(43) Date of publication of application: 12.12.2018
(73) Proprietor: Qualcomm Incorporated, San Diego, CA 92121-1714 (US)
(72) Inventor: BANSAL, Virendra, San Diego California 92121 (US); GULATI, Rahul, San Diego California 92121 (US); BHUYAN, Pranjal, San Diego California 92121 (US); JAIN, Palkesh, San Diego California 92121 (US)
(74) Representative: Carstens, Dirk Wilhelm
(86) International application number: PCT/US2017/012764
(87) International publication number: WO 2017/136107

(56) References cited:
- US-A1- 2003 098 705
- US-A1- 2007 188 155
- US-A1- 2015 241 553
- US-A1- 2016 025 790
- US-B1- 7 996 162

## Description

### CROSS-REFERENCE TO RELATED APPLICATION

This application claims priority to and the benefit of Non-Provisional Application No. 15/012,723 filed in the U.S. Patent and Trademark Office on February 1, 2016.

### TECHNICAL FIELD

This disclosure relates generally to robustness of integrated circuits (ICs) in a rigorous or fault-inducing environment and, more specifically, to enabling an integrated circuit to resist the deleterious effects resulting from a short-circuit condition that develops across a pair of communication pins of the integrated circuit.

### BACKGROUND

Integrated circuits are employed in numerous facets of modern life. For example, computing devices, such as internet servers and mobile phones, are powered by integrated circuit processors. Integrated circuits are further embedded in many different types of machines, from toys and televisions to cars and construction equipment. Although some of these integrated circuit applications are purely for diversion or otherwise involve low-risk activities, other applications involve critical or dangerous situations. Examples of critical or dangerous situations include moving vehicles, medical equipment, and so forth. In such critical or dangerous situations, an integrated circuit that succumbs to a faulty environment may lead not just to disappointment, but also to significant lost productivity or bodily injury, including a potential death of a passenger or patient.

In an effort to prevent an integrated circuit defect from contributing to a machine's malfunctioning, manufacturers inspect integrated circuits prior to sale. After being manufactured in a fabrication facility, an integrated circuit die that is formed on a silicon base is usually packaged in some manner, such as by being encased in plastic with external pins that lead to internal pads of the integrated circuit die. The packaged integrated circuit is then subjected to a series of tests, some of which may be performed using specialized automated testing equipment (ATE). The ATE runs the integrated circuit through a battery of tests in an attempt to verify that the integrated circuit was fabricated and packaged correctly and that the integrated circuit is able to provide appropriate outputs in response to at least a range of expected inputs. Unfortunately, conventional approaches to combating potential integrated circuit problems, such as testing by a manufacturer, are unable to prevent integrated circuits from exhibiting unexpected or undesired behavior. Consequently, conventional integrated circuits can fail to prevent, or may even contribute to causing, inconvenience, loss, and physical injury.

Attention is drawn to the document US 2007/188155 (A1). It describes a semiconductor integrated circuit device having an output portion that outputs via a switch element a predetermined voltage to the outside from a voltage output terminal through a voltage output line and a control portion that performs predetermined control based on a control signal inputted from outside to a signal input line or a signal input terminal that is so arranged as to be adjacent to a voltage output line or a voltage output terminal. A voltage detection portion is provided that detects that a voltage higher than a reference voltage is inputted to the signal input line or the signal input terminal and feeds the resultant signal to the output portion as a voltage detection signal, and the output portion opens the switch element when the voltage detection signal is provided thereto.

Further attention is drawn to US 7,996,162 (B1). It describes that the rates of change and difference between signals sensed at adjacent electronic module output ports are determined and compared to criteria to determine whether the output ports are shorted. Finally, attention is drawn to document US 2003/098705 (A1) describing an electric circuit system for detecting a short circuit between output PINs of different ICs, particularly CMOS-ICs, which in each case have a first switching element, particularly a highside transistor and a second switching element, particularly a lowside transistor as output driver, the first switching element and the second switching element of the respective output drivers having different source-drain resistances in the switched-on state.

### SUMMARY

In accordance with the present invention, an integrated circuit and a method for implementing a short-resistant output pin circuitry, as set forth in the independent claims, are provided. Embodiments of the invention are claimed in the dependent claims.

In an example aspect, an integrated circuit is disclosed. The integrated circuit includes a short-resistant pin and an adjacent pin. The integrated circuit also includes a short-resistant pad that is coupled to the short-resistant pin and an adjacent pad that is coupled to the adjacent pin. The integrated circuit further includes short-resistant circuitry that is coupled to the short-resistant pad and to the adjacent pad. The short-resistant circuitry is configured to detect a short-circuit condition between the short-resistant pin and the adjacent pin and to reduce an effect of the short-circuit condition on the short-resistant pin.

In an example aspect, an integrated circuit is disclosed. The integrated circuit includes a short-resistant pin and an adjacent pin. The integrated circuit also includes a short-resistant pad that is coupled to the short-resistant pin and an adjacent pad that is coupled to the adjacent pin. The integrated circuit further includes short-resistant means for preventing a short between the short-resistant pin and the adjacent pin from corrupting a signal output from the short-resistant pin. The short-resistant means is coupled to the short-resistant pad and the adjacent pad.

In an example aspect, a method for implementing short-resistant output pin circuitry is disclosed. The method includes monitoring an actual voltage level at an output of a short-resistant pin. The method also includes determining if the actual voltage level deviates from an intended voltage level for the output of the short-resistant pin. The method further includes controlling an output of an adjacent pin based on the determining.

### BRIEF DESCRIPTION OF DRAWINGS

FIG. 1 depicts an example of an integrated circuit having multiple communication pins, including a short-resistant pin and multiple adjacent pins.
FIG. 2 illustrates an example scenario for short-resistant output pin circuitry that includes a short-resistant pin and an adjacent pin, as well as short-resistant circuitry.
FIG. 3 illustrates an example correspondence between a device-oriented diagram and a resistor-oriented diagram that both include a short-resistant pin and an adjacent pin.
FIG. 4 depicts two graphs pertaining to example voltage levels for a short-resistant pin and an adjacent pin around a short-circuit condition for different relative drive strengths.
FIG. 5 illustrates an example of short-resistant circuitry that includes a short detector and an output controller.
FIG. 6 illustrates an example timing diagram for voltage levels of a short-resistant pin and an adjacent pin if a short occurs, both with and without short-resistant circuitry.
FIG. 7 illustrates another example of short-resistant circuitry that includes a short detector and an output controller in conjunction with input and output buffers of a short-resistant pad and an adjacent pad.
FIG. 8 illustrates an example of circuitry for a short detector of short-resistant circuitry.
FIG. 9 illustrates an example of circuitry for an output controller of short-resistant circuitry.
FIG. 10 is a flow diagram illustrating an example process for short-resistant output pin circuitry.

### DETAILED DESCRIPTION

Many integrated circuits (ICs) have a one-dimensional row or a two-dimensional matrix of input/output (I/O) pins along at least one edge or on one side of a package containing the integrated circuit. Due to a finite or limited area, the pins are likely to be spaced sufficiently close together such that a short between two adjacent pins may develop. If a short develops between two pins, an intended output of one pin may be affected by an output driven on the other pin. Consequently, one or both pins of a shorted pair of pins fails to drive the correct output that is intended by the integrated circuit.

Thus, one situation in which an integrated circuit can malfunction is in the presence of a short-circuit condition. With a short-circuit, an unexpected or undesired electrical connection occurs between two or more points of a circuit. This electrical connection can adversely impact intended signaling, such as the driving of a desired voltage level, of one or both points of the circuit that are experiencing the short-circuit. For example, a point at which a circuit is trying to generate a high level output of five volts (5 V) may instead be generating only a low level output under two volts (2 V). Incorrect signaling or processing is a likely result, which can lead to malfunctioning of a device using the integrated circuit.

A short-circuit, or short, can arise between two I/O terminals of an integrated circuit in a number of different manners. For example, packaging an integrated circuit die may introduce a short between two different I/O pads of the die. Additionally, a short may develop between two different I/O pins of a packaged integrated circuit when the integrated circuit is being installed on a printed circuit board (PCB) or in another environment. Furthermore, a short may develop over time due to vibration, corrosion, or other environmental effects.

Manufacturer testing of an integrated circuit may be capable of discovering a short or other problem with an integrated circuit die or a fully packaged integrated circuit at a manufacturing facility. Unfortunately, factory testing can be difficult for an integrated circuit that has been incorporated into a larger machine. Moreover, factory testing cannot detect ongoing environmental effects that can unexpectedly contribute to the creation of an undesired short after an integrated circuit is placed into service in the field. These inadequacies of factory-based testing can be genuinely dangerous if the integrated circuit is deployed in a critical role for a machine that is intended to provide a measure of safety, such as devices and equipment used in the medical and automotive fields.

One safety-critical usage scenario for integrated circuits involves automotive applications. For example, with an Advanced Driver Assistance System (ADAS), a dedicated pin of an integrated circuit is specified to report any faults in the integrated circuit, such as a system-on-a-chip (SoC), to other parts of an electronic or computing system of a vehicle. This dedicated pin is referred to herein as an "error pin." A false positive or a false negative on an error pin, including those false signals caused by a short with an adjacent pin of the error pin, can result in a catastrophic failure of a vehicle that may lead to a loss of life. Thus, accidents can be prevented and lives can be saved by making the error pin resistant against the effects of shorts with adjacent pins.

To address these reliability and safety issues, a pin of an integrated circuit can be made robust against faults, including faults caused by shorts with adjacent pins that develop after an integrated circuit is installed or put in operation as part of a larger machine. In example implementations, an integrated circuit is resistant to the effects of a short-circuit condition between two I/O pins while the integrated circuit is deployed in the field. During operation, a short detector attempts to detect a short-circuit condition between two pins of an integrated circuit. If a short-circuit condition is detected between two pins for instance, an effect of the short-circuit condition on a higher-priority pin is actively reduced. To detect a short-circuit condition, a voltage level of an output of a short-resistant pin is monitored using a loopback from an output buffer of a short-resistant pad that is coupled to the short-resistant pin. If the short-circuit condition is detected based on the voltage level of the short-resistant pin, a voltage level of an adjacent pin is controlled to at least reduce an effect of the short-circuit condition on the voltage level of the short-resistant pin.

More specifically, a voltage level corresponding to a particular logical value may be driven on the short-resistant pin even in the presence of a short with the adjacent pin by controlling the voltage level of the adjacent pin. For example, an output pad of the adjacent pin may be disabled to prevent a voltage level of the adjacent pin from substantially impacting an intended correct voltage level of the short-resistant pin. Alternatively, the voltage level of the adjacent pin may be driven at the same level that is intended for the short-resistant pin to eliminate contention over the actual resulting output voltage level.

In these manners, a pin of an integrated circuit can be made resistant to adverse effects of a short that occurs between the short-resistant pin and an adjacent pin. The short detection and amelioration can be performed by the integrated circuit after installation and while operating in the field. Thus, shorts can be detected and resulting malfunctions can be prevented for integrated circuits deployed in a safety-critical, or other mission-critical, application. For example, short-resistant circuitry can be implemented in conjunction with an error pin for an integrated circuit to be used in an ADAS application to ensure that an integrated circuit fault can be successfully reported to an electronic or computing system of a vehicle.

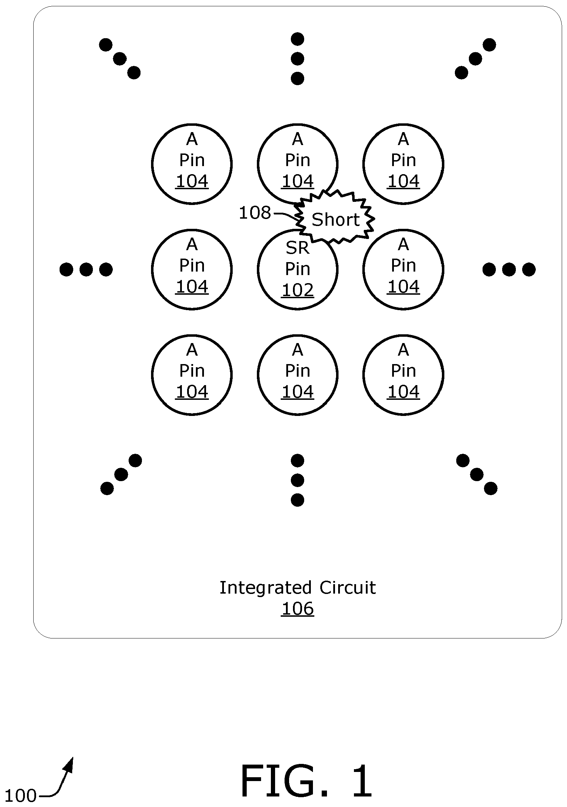

FIG. 1 depicts generally at 100 an example of an integrated circuit 106 having multiple communication pins, including a short-resistant pin 102 and multiple adjacent pins 104. Communication pins may be implemented as pins having an input or an output (I/O) functionality. The integrated circuit 106 may have at least one short-resistant (SR) pin and one or more adjacent (A) pins. As shown, one short-resistant pin 102 is surrounded by eight adjacent pins 104. A short 108 is depicted as being present between the short-resistant pin 102 and the upper central adjacent pin 104. A short 108 may be caused by, for instance, excess soldering material, a bent wire or other contact, corrosion, a combination thereof, and so forth.

The short 108 may adversely impact a voltage level output by the short-resistant pin 102 or the upper central adjacent pin 104 due to the unexpected electrical connection between the two pins. In certain implementations that are described herein, the short 108 is detected, and the adverse effects of the short 108 on the short-resistant pin 102 are ameliorated. Consequently, an intended voltage level output of the short-resistant pin 102 can be produced or maintained, even in the presence of the short 108. By way of example only, the short-resistant pin 102 may be implemented as an error pin in an ADAS environment.

Short-resistant output pin circuitry may be implemented in a variety of different situations with different numbers of I/O pins. For example, although shown as part of a matrix of pins in FIG. 1, a short-resistant pin 102 may be part of a line of I/O pins. Similarly, a short-resistant pin 102 may be located along an edge of a matrix of I/O pins. Additionally, short-resistant output pin circuitry can be implemented by an integrated circuit that includes multiple short-resistant pins. A specific example implementation is described below with regard to one short-resistant pin 102 and a single adjacent pin 104. However, short-resistant output pin circuitry may also be realized with multiple adjacent pins 104. For instance, detection and amelioration circuitry may be implemented with regard to two or three adjacent pins 104; with regard to four adjacent pins 104, such as with four pins that are disposed along cardinal directions (*e*.*g*., up-down-left-right) or with four pins that are disposed along diagonal directions; with regard to eight adjacent pins 104; or some combination thereof.

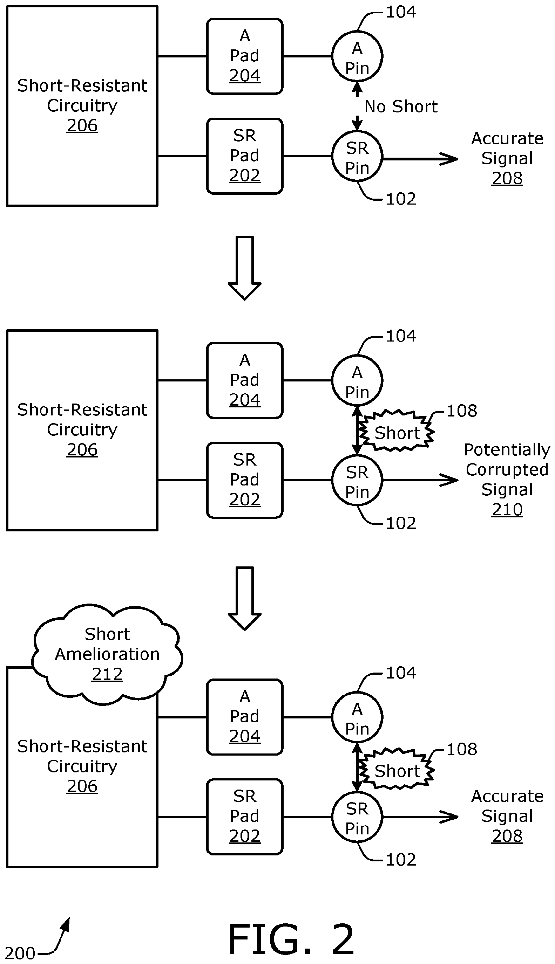

FIG. 2 illustrates an example scenario 200 for short-resistant output pin circuitry that includes a short-resistant pin 102 and an adjacent pin 104, as well as short-resistant circuitry 206. The scenario 200 includes three phases. At the top of FIG. 2, a first phase without a short is shown. In the middle phase, a short 108 is developing or has just occurred. At the bottom of FIG. 2, the short 108 has been ameliorated in the third phase. With a short amelioration 212, an adverse effect of the short 108 on the short-resistant pin 102 is reduced.

As shown, the adjacent pin 104 is coupled to an adjacent pad 204. The short-resistant pin 102 is coupled to a short-resistant pad 202. The short-resistant pad 202 and the adjacent pad 204 are coupled to the short-resistant circuitry 206. For the first phase, no short is present between the short-resistant pin 102 and the adjacent pin 104. Consequently, an accurate signal 208 can be output from the short-resistant pin 102. The accurate signal 208 represents or implies a voltage that is at a voltage level, or at least within a range of voltage levels, that is intended by the integrated circuit 106 (of FIG. 1). In other words, information, such as a logical value, that is intended to be carried by the accurate signal 208 is capable of being correctly received and interpreted by another integrated circuit or electronic component that is coupled to the short-resistant pin 102.

For the second phase of the scenario 200 in the middle of FIG. 2, the short 108 that is illustrated between the short-resistant pin 102 and the adjacent pin 104 is developing or has recently occurred. The short 108 adversely impacts an ability of the short-resistant pin 102 to output the accurate signal 208. As a result, a potentially corrupted signal 210 may be momentarily output by the short-resistant pin 102. A corrupted signal does not possess a voltage level to correctly convey intended information to a reliable degree. In other words, if not for the operation of the short-resistant circuitry 206, the signal output at the short-resistant pin 102 would be corrupted. From an alternative perspective, the signal that is output from the short-resistant pin 102 may be briefly corrupted while the short 108 is being detected and before the short can be ameliorated.

For the third phase of the scenario 200, at the bottom of FIG. 2, the short-resistant circuitry 206 is operational to achieve the short amelioration 212. With the short amelioration 212, the short-resistant pin 102 is empowered to again output or to continue to output the accurate signal 208, despite the presence of the short 108. In an example operation, the short-resistant circuitry 206 is configured to detect a short-circuit condition, which is caused by the short 108, between the short-resistant pin 102 and the adjacent pin 104 and to ameliorate the short-circuit condition responsive to the detection of the short 108. The short amelioration 212 can prevent the adjacent pin 104 from affecting (*e*.*g*., from substantially impacting) a voltage level on the short-resistant pin 102 if a short-circuit condition is detected. The adjacent pin 104 can be considered to be prevented from substantially impacting a voltage level of the short-resistant pin 102 if an intended voltage level is readable from the short-resistant pin 102, even in the presence of the short 108. The short-resistant circuitry 206 can prevent the short 108, which is between the short-resistant pin 102 and the adjacent pin 104, from corrupting a signal output from the short-resistant pin 102.

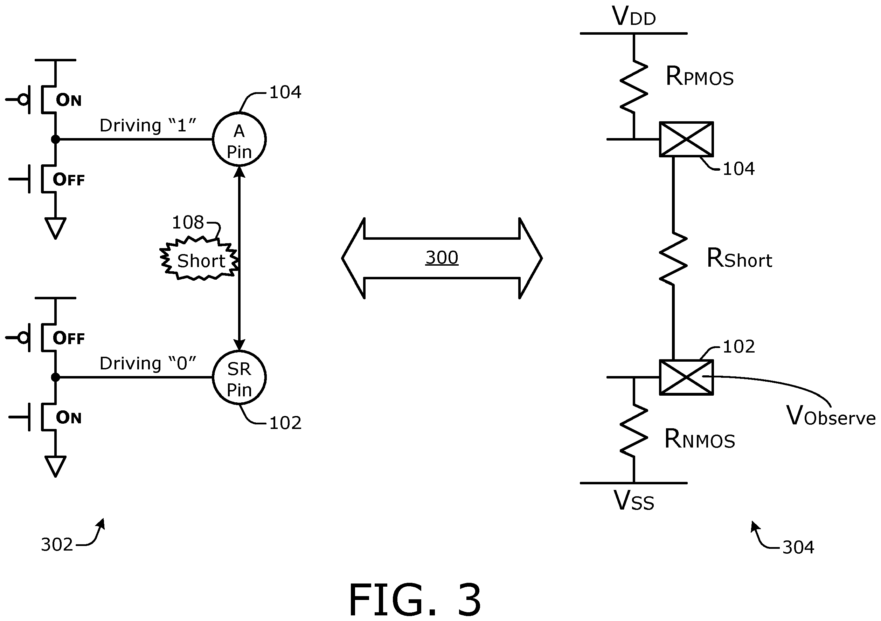

FIG. 3 illustrates an example correspondence 300 between a device-oriented diagram 302 and a resistor-oriented diagram 304 that include a short-resistant pin 102 and an adjacent pin 104. For the device-oriented diagram 302, transistors are depicted. For the resistor-oriented diagram 304, transistors that are turned on and the short 108 are modeled with resistors. Transistors that are turned off are modeled as an open circuit and are not depicted.

With reference to the device-oriented diagram 302, voltages are driven on output pins using two transistors. In an example implementation, a pair of field effect transistors (FETs) are coupled in series between a supply voltage and ground for each output pin. A p-type FET (PFET) is coupled to the supply voltage, and an n-type FET (NFET) is coupled to the ground. A node between the PFET and the NFET drives the voltage on the output pin.

A "1" or high voltage can be driven by turning on the upper PFET and turning off the lower NFET. Conversely, a "0" or low voltage can be driven by turning off the upper PFET and turning on the lower NFET. In an example scenario that is used to describe relative voltage levels for pins connected by the short 108, a "1" is driven on the adjacent pin 104, and a "0" is driven on the short-resistant pin 102. Thus, the PFET for the adjacent pin 104 is turned on, and the NFET for the short-resistant pin 102 is turned on.

The correspondence 300 is presented in terms of this example scenario in which the PFET for the adjacent pin 104 and the NFET for the short-resistant pin 102 are turned on. Thus, the resistor-oriented diagram 304 models the PFET as a resistor R_{PMOS} (*i*.*e*., the resistance (R) of a p-channel metal-oxide-semiconductor (PMOS) FET that is turned on), the NFET as a resistor R_{NMOS} (*i*.*e*., the resistance (R) of an n-channel metal-oxide-semiconductor (NMOS) FET that is turned on), and the short 108 as a resistor R_{Short}. These three resistors are coupled in series in the resistor-oriented diagram 304 between an upper voltage V_{DD} (*e*.*g*., a supply voltage (V_{DD})) and a lower voltage V_{SS} (*e*.*g*., a ground voltage (V_{SS})). The resistor R_{PMOS} is coupled between a node for the upper voltage V_{DD} and the adjacent pin 104. The resistor R_{Short} couples the adjacent pin 104 to the short-resistant pin 102. And the resistor R_{NMOS} is coupled between the short-resistant pin 102 and a node for the lower voltage V_{SS}.

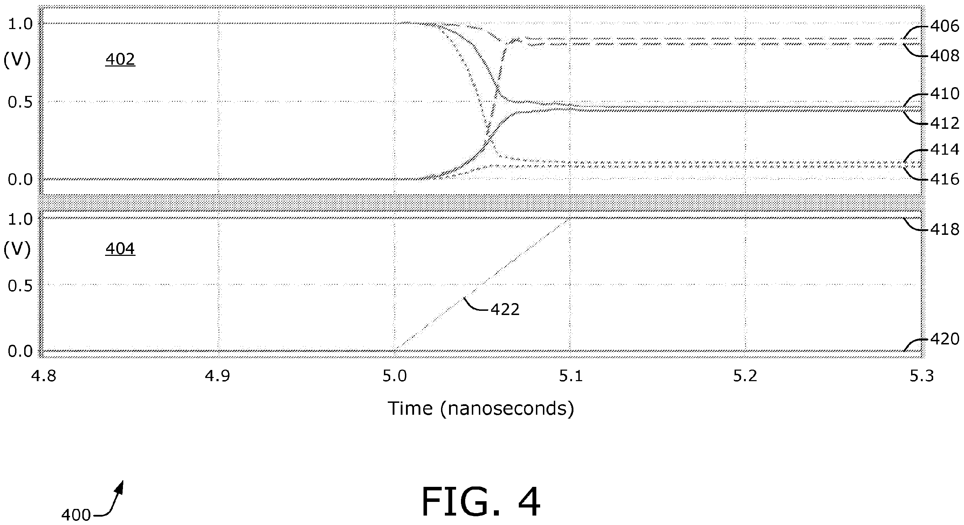

A voltage that is observed at the short-resistant pin 102 in the presence of the short 108 is termed V_{Observe} in the resistor-oriented diagram 304. A value or level of V_{Observe} depends on the voltages that are intended to be driven on the short-resistant pin 102 and the adjacent pin 104, as well as on the values of the resistances of the transistors that are turned on. The value of V_{Observe} further depends on relative strengths of the signals that are driven on the output pins. Examples of values that can be observed on the short-resistant pin 102 (*e*.*g*., V_{Observe}) and on the adjacent pin 104 in dependence on relative signal strengths thereof are described below with reference to the graphs of FIG. 4.

FIG. 4 depicts generally at 400 two graphs 402 and 404 that pertain to example voltage levels for a short-resistant pin 102 and an adjacent pin 104 (*e*.*g*., of FIG. 3) around a short-circuit condition for different relative drive strengths. Each graph includes waveforms of voltage levels that are exhibited shortly before, during development of, and shortly after a short-circuit condition. The abscissa or horizontal axis reflects time in nanoseconds from 4.8 to 5.3 nanoseconds. The ordinate or vertical axis reflects voltage (V) from 0.0 to 1.0 for each graph. The upper graph 402 represents observed output voltages if short-resistant circuitry is not operational or has not yet ameliorated a short-circuit condition, and the lower graph 404 represents the corresponding voltages that are intended to be driven by the short-resistant pin 102 and the adjacent pin 104. Nine waveforms 406-422 are depicted.

With reference to the lower graph 404, waveforms 418, 420, and 422 are depicted. Although the short-circuit activation is applicable to both graphs, the short-circuit activation is represented by the waveform 422 in the lower graph 404. As shown, the short-circuit condition develops over 0.1 nanoseconds between 5.0 and 5.1 nanoseconds. The waveform 418 indicates that the short-resistant pin 102 is intended to be driven at 1.0 volt over the 0.5 nanosecond timespan that extends from 4.8 to 5.3 nanoseconds. The waveform 420 indicates that the adjacent pin 104 is intended to be driven at 0.0 volts over the 0.5 nanosecond timespan.

With reference to the upper graph 402, waveforms 406, 408, 410, 412, 414, and 416 are depicted in pairs for three different cases. In the first case, the waveforms 406 and 408 relate to a situation in which the short-resistant pin 102 is driven relatively more strongly than the adjacent pin 104. The waveform 406 represents the voltage for the short-resistant pin 102, and the waveform 408 represents the voltage for the adjacent pin 104. In the second case, the waveforms 410 and 412 relate to a situation in which the driving strengths of the short-resistant pin 102 and the adjacent pin 104 are relatively balanced. The waveform 410 represents the voltage for the short-resistant pin 102, and the waveform 412 represents the voltage for the adjacent pin 104. In the third case, the waveforms 414 and 416 relate to a situation in which the adjacent pin 104 is driven relatively more strongly than the short-resistant pin 102. The waveform 414 represents the voltage for the short-resistant pin 102, and the waveform 416 represents the voltage for the adjacent pin 104.

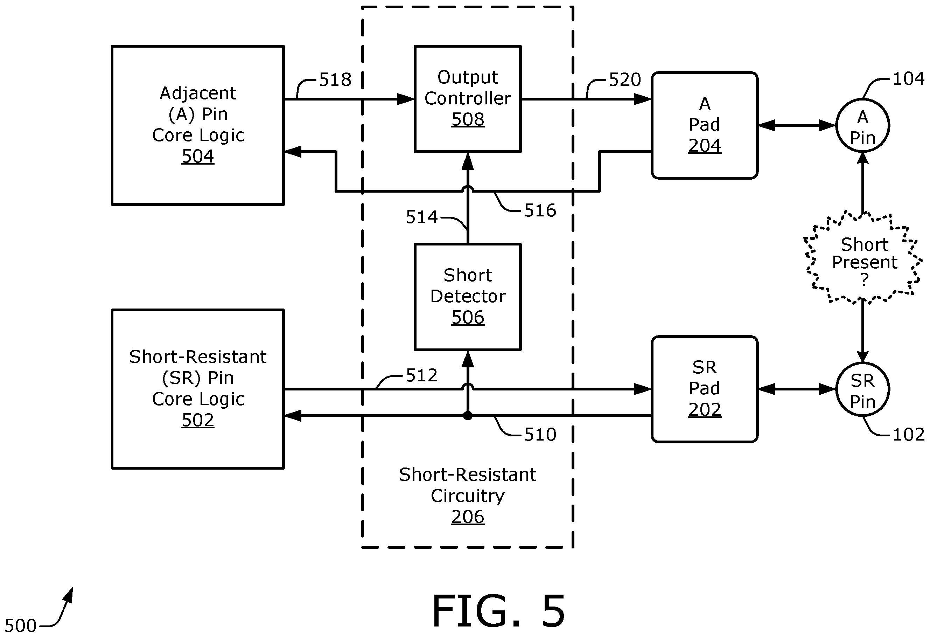

In each of the three cases, as the short-circuit condition develops, the output voltages on the pins are pulled away from the respective intended voltage levels. The voltage driven by the signal having the relatively weaker strength moves farther toward the other voltage driven by the relatively stronger strength. For instance, because the short-resistant pin 102 is driven relatively more strongly than the adjacent pin 104 in the first case, the voltage of the waveform 406 drops relatively slightly from the 1.0 V voltage level intended for the short-resistant pin 102, but the voltage of the waveform 408 rises relatively significantly from the 0.0 V voltage level intended for the adjacent pin 104. The opposite is true for the waveforms 414 and 416. In each of the three cases, the output voltage levels that result from the occurrence of the short-circuit condition move toward the central voltage (*e*.*g*., 0.5 V) into an intermediate voltage range away from the 0.0 V and 1.0 V voltages. The occurrence of a voltage level within this intermediate voltage range can be used as part of a technique to detect the occurrence of a short-circuit condition, which technique is described further below with reference to at least FIGS. 5, 6, and 8.

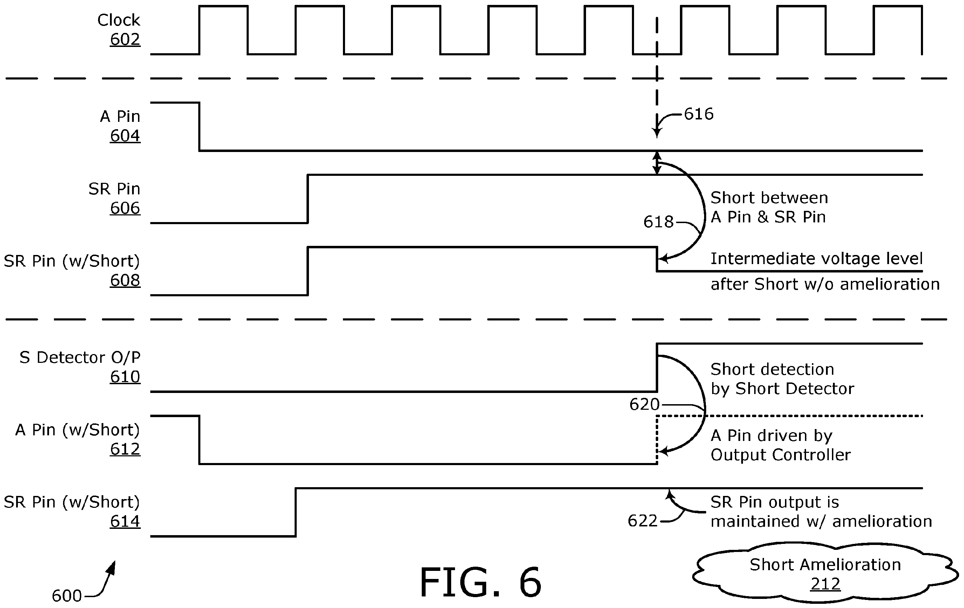

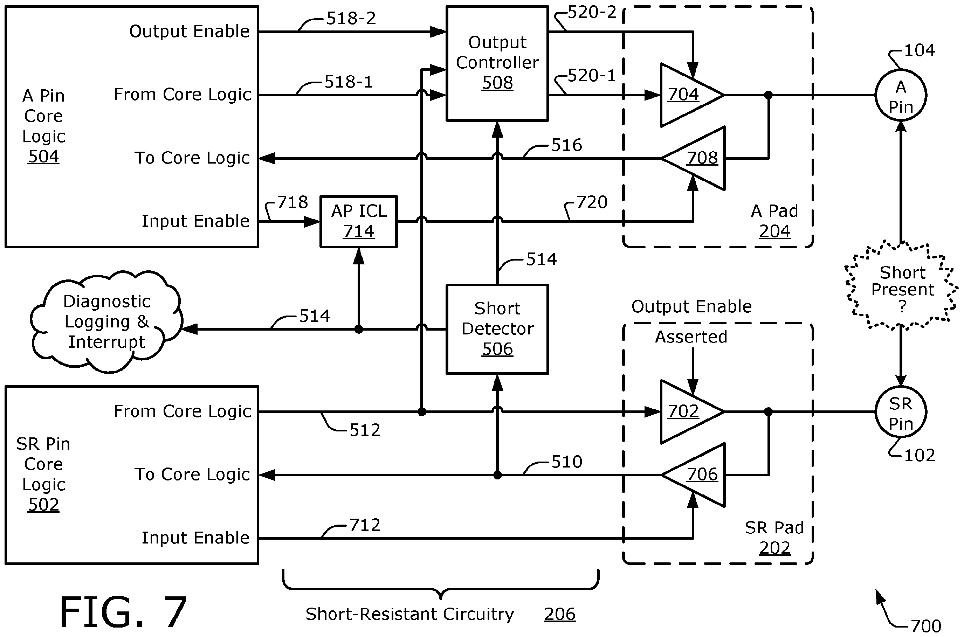

FIG. 5 illustrates generally at 500 an example of short-resistant circuitry 206 that includes a short detector 506 and an output controller 508. Multiple signals 510, 512, 514, 516, 518, and 520 are illustrated propagating between or among the illustrated components of an integrated circuit. Each of the signals may be realized using one or more different voltage levels (*e*.*g*., low, high, and intermediate voltage levels). Although not illustrated separately from the arrows representing the signals, the voltages may be produced on or extant across a wire, a trace, a metal strip, or a combination thereof of an integrated circuit. Examples of voltage levels are described below with reference to a timing diagram of FIG. 6. Each signal may further include one or more other signals, as described below with reference to FIG. 7.

As shown in FIG. 5, core logic for an integrated circuit is represented by short-resistant pin core logic 502 and adjacent pin core logic 504. Core logic includes circuitry (not explicitly shown) that enables functionality corresponding to a given pin to be implemented. Thus, the short-resistant pin core logic 502 is capable of performing functionality corresponding to the short-resistant pin 102, and the adjacent pin core logic 504 is capable of performing functionality corresponding to the adjacent pin 104.

In an example implementation, the short-resistant pin 102 is responsible for communicating critical information, such as a signal indicative that an air bag should be deployed, a signal reporting that an internal fault has been experienced by the integrated circuit, and so forth. The short-resistant pin core logic 502 processes data to produce such a signal. The adjacent pin 104 is responsible for less critical communications. Examples include a signal indicative of low tire pressure, a signal representing pixels on a display screen, a bit of a memory address, and so forth. The adjacent pin core logic 504 processes this relatively less critical incoming or outgoing data accordingly.

In example implementations, the short-resistant circuitry 206 includes the short detector 506 and the output controller 508. Generally, the short detector 506 is configured to detect a short-circuit condition between the short-resistant pin 102 and the adjacent pin 104. And the output controller 508 is configured to ameliorate the detected short-circuit condition by reducing an effect of the short-circuit condition on a voltage level of an output of the short-resistant pin.

The short-resistant pin core logic 502 is coupled to the short-resistant pad 202. The short-resistant pad 202 communicates the signal 510 to the short-resistant pin core logic 502 and to the short detector 506 of the short-resistant circuitry 206. The signal 510 is a loopback of the voltage on an output of the short-resistant pad 202. Consequently, the short detector 506 can monitor the voltage level of the output signal on the short-resistant pin 102. Furthermore, if the short-resistant pad 202 includes an input capability, the short-resistant pin core logic 502 can receive incoming signals from the short-resistant pin 102. For outgoing signals, the short-resistant pin core logic 502 communicates the signal 512 to the short-resistant pad 202. Thus, the short-resistant pin core logic 502 can provide an output signal, such as an error report, for the short-resistant pin 102.

The short detector 506 is configured to monitor the voltage level of the output of the short-resistant pin 102 based on the signal 510. The short detector 506 is also configured to provide a detection alert indicator to the output controller 508 responsive to the voltage level of the output of the short-resistant pin 102. The detection alert indicator is asserted if a short is detected by the short detector 506. The short detector 506 provides the detection alert indicator to the output controller 508 via the signal 514. The short detector 506 can detect the short 108 (of FIG. 2) between the short resistant pin 102 and the adjacent pin 104 based on a voltage level output by the short-resistant pin 102 using the short-resistant pad 202.

The adjacent pin core logic 504 is coupled to the adjacent pad 204. The adjacent pad 204 communicates the signal 516 to the adjacent pin core logic 504. The signal 516 provides data to the adjacent pin core logic 504 that is input to the integrated circuit via the adjacent pin 104. The adjacent pin core logic 504 is also coupled to the output controller 508. The adjacent pin core logic 504 communicates the signal 518 to the output controller 508. The signal 518 can carry output data for the adjacent pin core logic 504. The output data is routed through the output controller 508 so that the output controller 508 can act as a gateway for data output functionality for the adjacent pin 104.

The output controller 508 controls an output of the adjacent pad 204 for the adjacent pin 104 using the signal 520. The output controller 508 can control the output of the adjacent pin 104 to at least reduce an impact of the adjacent pin 104 on a voltage level of a signal output by the short-resistant pin 102 based on the signal 514 from the short detector 506. If the detection alert indicator of the signal 514 is not asserted, the output controller 508 forwards the voltage level of the signal 518 onto the signal 520 to enable the adjacent pin core logic 504 to output desired data on the adjacent pin 104 via the adjacent pad 204.

On the other hand, if the detection alert indicator of the signal 514 is asserted, the output controller 508 configures the signal 520 so that the output of the adjacent pin 104 does not corrupt the intended signal at the short-resistant pin 102, even in the presence of a short between the adjacent pin 104 and the short-resistant pin 102. For example, the output controller 508 can use the signal 520 to disable the output of the adjacent pad 204. Alternatively, the output controller 508 can use the signal 520 to cause the adjacent pad 204 to drive a signal on the adjacent pin 104 that is the same as the intended signal for the short-resistant pin 102. The output controller 508 can control the voltage level of the adjacent pin 104 by causing an output of the adjacent pin 104 to have a voltage value that corresponds to a correct voltage level for the short-resistant pin 102, with the correct voltage level indicated by the short-resistant pin core logic 502. The output controller 508 can control an output of the adjacent pin 104 to prevent the short 108 (of FIG. 2) from corrupting the signal output from the short-resistant pin 102. These example implementations, as well as additional details including buffers of the communication pads and additional communicated signals, are described further below with reference to FIG. 7.

FIG. 6 illustrates an example timing diagram 600 for voltage levels of a short-resistant pin 102 and an adjacent pin 104 (of FIG. 5) if a short occurs between the two pins. In addition to a clock signal 602, voltage signals at multiple different components, such as different pins, are shown. The timing diagram 600 includes upper, middle, and lower portions. The upper portion depicts the clock signal 602. The middle portion depicts voltage levels if a short occurs in the absence of short-resistant circuitry. The lower portion depicts voltage levels if a short occurs with short-resistant circuitry. A short occurs after the fifth falling edge of the clock signal 602 as shown at an arrow 616.

In the middle portion of the timing diagram 600, an adjacent pin signal 604 is driven low at the first rising edge of the clock signal 602. At the second rising edge of the clock signal 602, a short-resistant pin signal 606 is driven high. The intended voltage level for the short-resistant pin 102 is therefore high. However, the short between the adjacent pin 104 and the short-resistant pin 102, which occurs at the arrow 616, adversely impacts the intended voltage level in the absence of short-resistant circuitry. A short-resistant pin (with short) signal 608 reflects this adverse impact. As indicated at an arrow 618, the short-resistant pin (with short) signal 608 takes on an intermediate voltage level after the short in the absence of efforts to ameliorate the short. This intermediate voltage fails to convey the intended signal on the short-resistant pin 102.

In the lower portion of the timing diagram 600, voltage levels of signals on the short-resistant pin 102 and the adjacent pin 104 are shown in the presence of the short amelioration 212 that is effectuated by the short-resistant circuitry 206 (of FIG. 5). A short detector output signal 610 is asserted (*e*.*g*., goes high) responsive to the occurrence of the short at the arrow 616 because the short detector 506 detects the existence of the short based on the intermediate voltage that occurs momentarily on the short-resistant pin 102. The output controller 508 causes an adjacent pin (with short) signal 612 to go high as indicated by the dotted line. In other words, as indicated by an arrow 620, the adjacent pin 104 is driven by the output controller 508 responsive to the assertion of the short detector output signal 610. Because the ameliorated version of the adjacent pin (with short) signal 612 is also a high voltage, the voltage level of the adjacent pin 104 does not conflict with the voltage level of the short-resistant pin 102. Consequently, the short-resistant pin (with short) signal 614 continues to be held at a high voltage after the occurrence of the short. In other words, as indicated by an arrow 622, an output of the short-resistant pin 102 is maintained at an intended voltage level due to the amelioration efforts of the short-resistant circuitry 206.

FIG. 7 illustrates generally at 700 another example of short-resistant circuitry 206 that includes the short detector 506 and the output controller 508 in conjunction with input and output buffers of the short-resistant pad 202 and the adjacent pad 204. In comparison to FIG. 5, FIG. 7 depicts additional example components and implementations. As shown in FIG. 7, the short-resistant pad 202 includes an output buffer 702 and an input buffer 706, and the adjacent pad 204 includes an output buffer 704 and an input buffer 708. The signal 518 between the adjacent pin core logic 504 and the output controller 508 is shown to include two signals: a signal 518-1 and a signal 518-2. Similarly, the signal 520 between the output controller 508 and the adjacent pad 204 is shown to include two signals: a signal 520-1 and a signal 520-2. One additional component of the short-resistant circuitry 206 is also depicted: adjacent pin input control logic 714 (AP ICL). Signals associated with this input control logic component include signals 718 and 720.

In example implementations, the short detector 506 also provides the signal 514 having a detection alert indicator to the adjacent pin input control logic 714 and to logic for handling diagnostic logging and interrupts. For diagnostic logging purposes, detected shorts may be recorded, cataloged, and analyzed. For interrupt purposes, a detected short may precipitate an interrupt of one or more processes that are onboard the integrated circuit or a forwarding of the interrupt to another integrated circuit.

In an example implementation, an output enable terminal of the output buffer 702 is asserted so that information, such as a fault report or other data that is provided from the short-resistant pin core logic 502 via the signal 512, can be made available as an output on the short-resistant pin 102 via the short-resistant pad 202. The short-resistant pin core logic 502 can enable the input buffer 706 of the short-resistant pad 202 by providing an input enable indication (*e*.*g*., by asserting) an input enable terminal of the input buffer 706 using the signal 712. If enabled, the input buffer 706 is capable of providing data that is input to the integrated circuit via the short-resistant pin 102 to the short-resistant pin core logic 502 via the signal 510. The input buffer 706 of the short-resistant pad 202 can also provide via the signal 510 for short detection purposes a loopback of the actual voltage produced on the output of the output buffer 702, which corresponds to the output for the short-resistant pin 102.

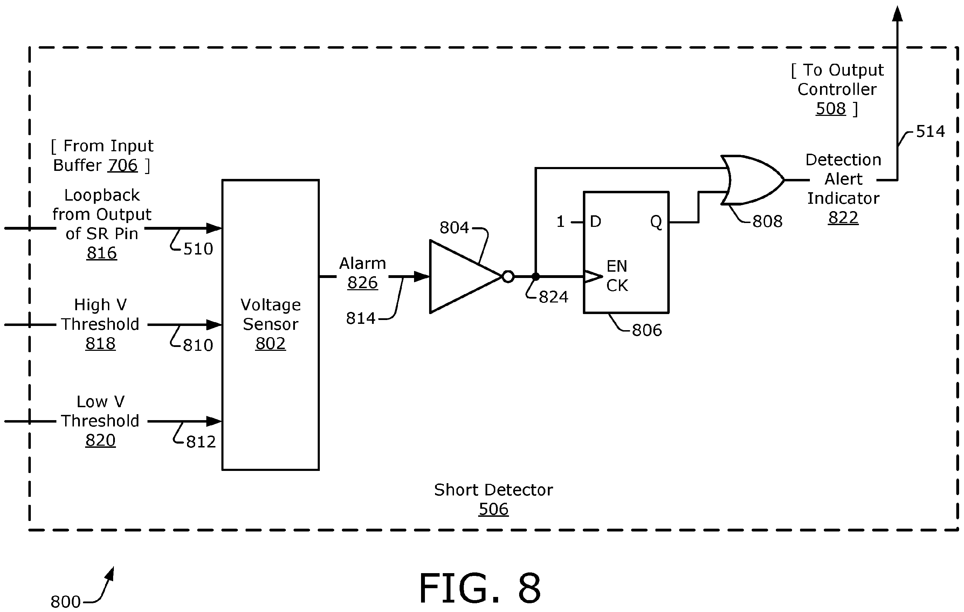

Thus, the short detector 506 monitors the voltage on the output of the short-resistant pin 102, which is obtained via the signal 510 as a loopback from the output of the short-resistant pad 202, to detect a short-circuit condition. In an example implementation, the short detector 506 determines if a short-circuit condition exists based on a comparison of the voltage on the output of the short-resistant pin 102 to a high voltage threshold and a low voltage threshold. This implementation is described further below with reference to FIG. 8. In another example implementation, the short detector 506 determines if a short-circuit condition exists based on a comparison of the voltage on the output of the short-resistant pin 102 to an intended or correct voltage level that is indicated by the short-resistant pin core logic 502, such as via the signal 512. (Although not explicitly shown in FIG. 7, the signal 512 can be routed to the short detector 506.) The short detector 506 determines the existence of a short if the loopback voltage level deviates from the intended voltage level by more than a deviation threshold. The deviation threshold may be based on an absolute number of volts *(e.g.,* 0.05 V, 0.10 V, etc.), based on a percentage of the intended high voltage level or maximum voltage differential between low and high signal levels *(e.g.,* 5% thereof, 10% thereof, etc.), based on a tolerance for signal variation in a given system, based on a combination thereof, and so forth.

The adjacent pin input control logic 714 controls the input of the adjacent pin 104 by controlling an input enable terminal of the input buffer 708 of the adjacent pad 204. In a regular operational mode, the adjacent pin core logic 504 provides the signal 718 to the adjacent pin input control logic 714 as an input enable indication for the input buffer 708. In the regular operational mode, the adjacent pin input control logic 714 passes the input enable indication of the signal 718 to the input enable terminal of the input buffer 708 via the signal 720. In a short amelioration mode, however, the adjacent pin input control logic 714 overrides the signal 718 responsive to an asserted detection alert indicator of the signal 514. If the detection alert indicator is asserted, the adjacent pin input control logic 714 disables the input buffer 708 via the signal 720 to safeguard the adjacent pin core logic 504. The adjacent pin input control logic 714 may be implemented using, for example, a two-to-one multiplexer that has the signal 718 as one input and a preset de-assertion signal as another input and that is controlled by the detection alert indicator of the signal 514. If enabled, the input buffer 708 of the adjacent pad 204 is capable of providing data that is input to the integrated circuit via the adjacent pin 104 to the adjacent pin core logic 504 via the signal 516. Although not shown in FIG. 7, short-resistant pin input control logic may additionally or alternatively be implemented. If implemented, short-resistant pin input control logic can operate analogously to the adjacent pin input control logic 714. For example, short-resistant pin input control logic can override the signal 712 responsive to an asserted detection alert indicator of the signal 514 and disable the input buffer 706 via another signal (not explicitly shown) coupled to the input enable terminal of the input buffer 706.

Multiple signals are sent to or sent from the output controller 508. The short detector 506, for instance, provides the signal 514 that is asserted as a detection alert indicator if a short is detected. The short-resistant pin core logic 502 provides the signal 512, which represents data to be outputted by the short-resistant pin 102-such as a fault indication, to the output controller 508. The adjacent pin core logic 504 provides the signal 518-1, which carries data, and the signal 518-2, which carries an output enable indication, to the output controller 508. The output controller 508 routes data via the signal 520-1 to the output buffer 704 of the adjacent pad 204 for exposure on the adjacent pin 104. The output controller 508 also provides an output enable indication via the signal 520-2 to an output enable terminal of the output buffer 704.

In a regular operational mode, the output controller 508 passes data received from the adjacent pin core logic 504 via the signal 518-1 to the output buffer 704 via the signal 520-1. The output controller 508 also forwards an output enable indication, which can be asserted or de-asserted, received from the adjacent pin core logic 504 via the signal 518-2 to the output enable terminal of the output buffer 704 via the signal 520-2. A short amelioration mode is entered responsive to assertion of the detection alert indicator of the signal 514 from the short detector 506. In the short amelioration mode, the output controller 508 controls an output of the adjacent pin 104 by controlling the output buffer 704 to reduce an impact of the adjacent pin 104 on the short-resistant pin 102 in the event that the integrated circuit experiences a short.

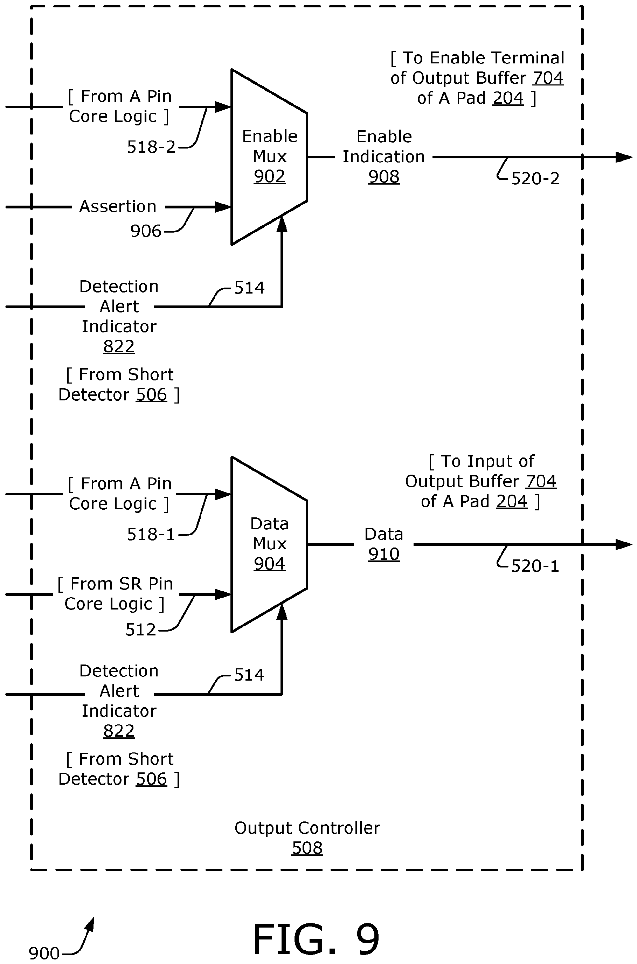

In an example implementation for the short amelioration mode, the output controller 508 uses the signal 520-2 to de-assert the output enable terminal of the output buffer 704 to prevent the adjacent pad 204 from driving a voltage on the adjacent pin 104. In an alternative implementation, the output controller 508 provides a voltage level to the output buffer 704 via the signal 520-1. The voltage level on the signal 520-1 is set to match the voltage level received from the short-resistant pin core logic 502 via the signal 512. The output controller 508 also asserts the output enable terminal of the output buffer 704 via the signal 520-2. Consequently, the output buffer 704 drives a voltage level on the adjacent pin 104 that is the same as the voltage being driven by the output node 702 on the short-resistant pin 102, which reduces contention. These implementations are described further below with reference to FIG. 9.

FIG. 8 illustrates generally at 800 an example of circuitry for the short detector 506 of the short-resistant circuitry 206 (of FIG. 7). As illustrated, the short detector 506 includes a voltage sensor 802, an inverter 804, a DQ flip-flop 806, and an OR gate 808. Generally, the voltage sensor 802, the inverter 804, the DQ flip-flop 806, and the OR gate 808 are coupled in series from left to right in FIG. 8. On the left, the short detector 506 is provided three signals 510, 810, and 812, each of which is fed to the voltage sensor 802. The signal 510 is received from the input buffer 706 of the short-resistant pad 202 (both of FIG. 7) and carries the voltage of the loopback 816 from the output of the short-resistant pad 202 of the short-resistant pin 102. The signal 810 provides a high voltage threshold 818, and the signal 812 provides a low voltage threshold 820.

In an example operation, the voltage sensor 802 compares the voltage level of the loopback 816 to the high voltage threshold 818 and the low voltage threshold 820. If the voltage level of the loopback 816 is above the high voltage threshold 818 or below the low voltage threshold 820, no alarm is generated. On the other hand, if the voltage level of the loopback 816 is below the high voltage threshold 818 and above the low voltage threshold 820, the voltage sensor 802 generates an alarm 826. In other words, if the voltage level of the loopback 816 is between the low voltage threshold 820 and the high voltage threshold 818, the voltage level is at an intermediate voltage value indicative of a short-circuit condition. The voltage sensor 802 can generate an alarm 826 that is indicative of the short 108 (of FIG. 2) based on the voltage level output by the short-resistant pin 102, a high voltage threshold 818, and a low voltage threshold 820. The voltage sensor 802 provides the alarm 826 as a signal 814 to an input of the inverter 804.

In this example, the alarm 826 is asserted by driving the voltage at the input of the inverter 804 low. Consequently, the voltage at the output of the inverter 804, which is designated as a node 824, becomes high. The node 824 is coupled to a clock enable input of the DQ flip-flop 806 and to an upper input of the OR gate 808. The "D" input of the DQ flip-flop 806 is tied to a high voltage as represented by the "1." The "Q" output is coupled to a lower input of the OR gate 808. The change of voltage level at the output of the inverter 804 simulates a rising edge of a clock signal at the node 824. The rising edge of the simulated clock signal triggers the DQ flip-flop 806. The triggered DQ flip-flop 806 propagates the "1" at the "D" input to the "Q" output of the DQ flip-flip 806. The high voltage at the node 824 due to the assertion of the signal 814 as the alarm 826 causes the OR gate 808 to output a high voltage for an assertion of the detection alert indicator 822.

The DQ flip-flop 806 serves to latch the alarm 826 that indicates a short detection. The indication can be stored until cleared by software or other hardware. The short detector 506 outputs the asserted detection alert indicator 822 as the signal 514, which is communicated to the output controller 508. An example of how the output controller 508 uses and responds to the asserted detection alert indicator 822 is described below with reference to FIG. 9.

FIG. 9 illustrates generally at 900 an example of circuitry for the output controller 508 of the short-resistant circuitry 206 (of FIG. 7). As shown, the output controller 508 includes two multiplexers: an enablement multiplexer 902 and a data multiplexer 904. Both are two-to-one multiplexers that select from between two inputs an output for forwarding based on the detection alert indicator 822. The detection alert indicator 822 is provided to a control terminal of each multiplexer as the signal 514, which is received from the short detector 506. If the detection alert indicator 822 is asserted, a short amelioration mode is entered and each multiplexer switches from selecting an upper input to selecting a lower input.

The enablement multiplexer 902 has an upper input that receives an enable indication from the adjacent pin core logic 504 as the signal 518-2. The enablement multiplexer 902 has a lower input that receives a preset assertion signal 906. The enablement multiplexer 902 outputs an enable indication 908 as the signal 520-2 to the output enable terminal of the output buffer 704 of the adjacent pad 204 (of FIG. 7). The enablement multiplexer 902 can multiplex from an enablement signal corresponding to the adjacent pin core logic 504 (*e*.*g*., the signal 518-2 carrying an enable indication) to the assertion signal 906 responsive to detection of the short 108 (of FIG. 2) between the short-resistant pin 102 and the adjacent pin 104.

The data multiplexer 904 has an upper input that receives data from the adjacent pin core logic 504 as the signal 518-1. The data multiplexer 904 has a lower input that receives data from the short-resistant pin core logic 502 as the signal 512. The data multiplexer 904 outputs data 910 as the signal 520-1 to the input of the output buffer 704 of the adjacent pad 204. The data multiplexer 904 can multiplex from a first data signal for the adjacent pin 104 (*e*.*g*., the signal 518-1 carrying data from the adjacent pin core logic 504) to a second data signal for the short-resistant pin 102 (*e*.*g*., the signal 512 carrying data from the short-resistant pin core logic 502) responsive to detection of the short 108 between the short-resistant pin 102 and the adjacent pin 104.

In a regular operational mode, the detection alert indicator 822 from the short detector 506 is not asserted. The enablement multiplexer 902 forwards an enable indication from the adjacent pin core logic 504 as the enable indication 908 for the signal 520-2. The data multiplexer 904 forwards data from the adjacent pin core logic 504 as the data 910 for the signal 520-1. Thus, for the regular operational mode, the output controller 508 forwards the enable indication and the data from the adjacent pin core logic 504 to the output buffer 704 of the adjacent pad 204.

In contrast, for a short amelioration mode, the detection alert indicator 822 from the short detector 506 is asserted. In one implementation, a preset de-assertion signal (not shown) may be multiplexed from the lower input of the enablement multiplexer 902 as the enable indication 908 for the signal 520-2 to disable the output buffer 704 of the adjacent pad 204 to prevent the adjacent pin 104 from conflicting with the short-resistant pin 102. In an alternative implementation, the enablement multiplexer 902 provides the preset assertion signal 906 as the enable indication 908 for the signal 520-2 in response to the asserted detection alert indicator 822. The data multiplexer 904 also provides data from the short-resistant pin core logic 502 as the data 910 for the signal 520-1. Thus, for this implementation of the short amelioration mode, the output controller 508 provides an asserted enable indication and data from the short-resistant pin core logic 502 to the output buffer 704 of the adjacent pad 204. Because both the adjacent pin 104 and the short-resistant pin 102 are outputting data received from the same source, which is the short-resistant pin core logic 502, the voltage levels and the corresponding logical values that are output on both pins are the same and do not create contention with each other.

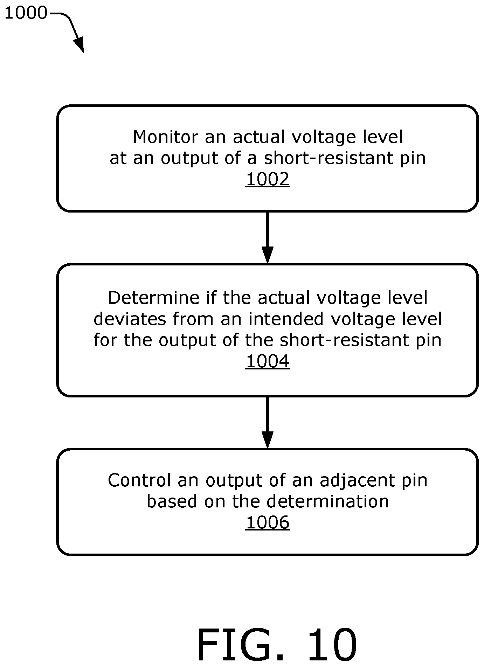

FIG. 10 is a flow diagram illustrating an example process 1000 for short-resistant output pin circuitry. Process 1000 is described in the form of a set of blocks 1002-1006 that specify operations that may be performed. However, operations are not necessarily limited to the order shown in FIG. 10 or described herein, for the operations may be implemented in alternative orders or in fully or partially overlapping manners. Operations represented by the illustrated blocks of process 1000 may be performed by an integrated circuit, such as an integrated circuit 106 of FIG. 1, which is described above. For example, the operations of process 1000 may be performed by the short-resistant circuitry 206 of FIGS. 5 and 7.

At block 1002, an actual voltage level at an output of a short-resistant pin is monitored. For example, short-resistant circuitry 206 of an integrated circuit 106 may monitor an actual voltage level at an output of a short-resistant pin 102. For instance, a short detector 506 can receive a voltage level via a loopback 816 of an output of a short-resistant pad 202 for the short-resistant pin 102, the voltage level carried on a signal 510 that is provided from an input buffer 706 of the short-resistant pad 202.

At block 1004, whether the actual voltage level for the output of the short-resistant pin deviates from an intended voltage level for the output of the short-resistant pin is determined. For example, the short-resistant circuitry 206 may determine if the actual voltage level obtained with the loopback 816 from the output of the short-resistant pin 102 via the input buffer 706 deviates from an intended voltage level for the output of the short-resistant pin 102 at the output buffer 702. This determination may be at least partially effectuated by the short detector 506 by, for instance, comparing the voltage level of the signal 510 from the input buffer 706 to a voltage level from a short-resistant pin core logic 502 that is provided to the output buffer 702 for the short-resistant pin 102. If the voltage value provided for outputting on the short-resistant pin 102 is different from the monitored actual voltage on the short-resistant pin 102 by more than a deviation threshold, the existence of a short 108 between the short-resistant pin 102 and an adjacent pin 104 can be inferred.

At block 1006, an output of an adjacent pin is controlled based on the determining. For example, the short-resistant circuitry 206 may control an output of the adjacent pin 104 based on the determining. To do so, an output controller 508 can permit adjacent pin core logic 504 to drive an output buffer 704 of an adjacent pad 204 if the actual voltage level of the short-resistant pin 102 is not determined to deviate from the intended voltage level. However, if the actual voltage level of the short-resistant pin 102 is determined to deviate from the intended voltage level as indicated by a detection alert indicator 822 that is provided to the output controller 508, the output controller 508 can control the output of the adjacent pin 104 such that the adjacent pin 104 does not continue to cause the actual voltage level of the short-resistant pin 102 to deviate from the intended voltage level thereof.

In an example implementation, for the monitoring of block 1002, the output of the short-resistant pin corresponds to an output buffer of a short-resistant pad that is coupled to the short-resistant pin, and the monitoring includes monitoring the actual voltage level at the output buffer of the short-resistant pad. For example, the output of the short-resistant pin 102 may correspond to an output buffer 702 of a short-resistant pad 202 that is coupled to the short-resistant pin 102, and the monitoring may include monitoring the actual voltage level at the output buffer 702 of the short-resistant pad 202. This monitoring of the output of the output buffer 702 may be accomplished using an input buffer 706 of the short-resistant pad 202 that loops the actual output voltage back to short-resistant circuitry 206 for short detection analysis by the short detector 506.

In an example implementation, the determination of block 1004 includes comparing the actual voltage level to a high voltage threshold and a low voltage threshold and determining that the actual voltage level deviates from the intended voltage level if the actual voltage level is between the high voltage threshold and the low voltage threshold. For example, the short detector 506 *(e.g.,* the voltage sensor 802) may compare the actual voltage level obtained from the input buffer 706 of the short-resistant pad 202 to a high voltage threshold 818 and a low voltage threshold 820. The short detector 506 may also determine that the actual voltage level deviates from the intended voltage level obtained from the short-resistant pin core logic 502 if the actual voltage level is between the high voltage threshold 818 and the low voltage threshold 820.

In another example implementation, the determination of block 1004 includes comparing the actual voltage level to the intended voltage level, with the intended voltage level indicated by short-resistant pin core logic, and determining that the actual voltage level deviates from the intended voltage level if the actual voltage level deviates from the intended voltage level by more than a deviation threshold. For example, the short detector 506 may compare the actual voltage level obtained from the input buffer 706 of the short-resistant pad 202 to the intended voltage level, which is provided by the short-resistant pin core logic 502. The short detector 506 may also determine that the actual voltage level deviates from the intended voltage level if the actual voltage level deviates from the intended voltage level by more than a deviation threshold, such as 0.1 V or 5% of a voltage swing between low and high voltage levels.

In an example implementation, the controlling of block 1006 includes disabling the output of the adjacent pin if the actual voltage level is determined to deviate from the intended voltage level. For example, the output controller 508 may disable an output of the adjacent pin 104 by de-asserting an output enable terminal of the output buffer 704 of the adjacent pad 204.

In another example implementation, the controlling of block 1006 includes causing the output of the adjacent pin to be driven at the intended voltage level if the actual voltage level at the output of the short-resistant pin is determined to deviate from the intended voltage level for the output of the short-resistant pin. For example, the output controller 508 may cause the output of the adjacent pin 104 to be driven at a voltage level provided by the short-resistant pin core logic 502 via the signal 512 if the actual voltage level at the output of the short-resistant pin 102 as obtained by the short detector 506 from the input buffer 706 deviates from the intended voltage level for the output of the short-resistant pin 102.

In an example implementation, the process 1000 also includes, after the controlling operation, a repeating of the monitoring and the determining operations. If the actual voltage level of the output of the short-resistant pin continues to deviate from the intended voltage level, the process 1000 further includes controlling an output of a second adjacent pin. In other words, if a first amelioration effort with respect to a first adjacent pin 104 is unsuccessful, a second amelioration effort with respect to a second adjacent pin 104 may be effected. The short-resistant circuitry 206 can continue to control the output of different adjacent pins 104 until the short-circuit condition is ameliorated and the adjacent pin 104 involved in the short 108 is implicitly ascertained.

Unless context dictates otherwise, use herein of the word "or" may be considered use of an "inclusive or," or a term that permits inclusion or application of one or more items that are linked by the word "or" (*e*.*g*., a phrase "A or B" may be interpreted as permitting just "A," as permitting just "B," or as permitting both "A" and "B"). Although subject matter has been described in language specific to structural features or methodological operations, it is to be understood that the scope of protection is defined in the appended claims.

## Claims

1. An integrated circuit (500) comprising:
a short-resistant pin (102);
an adjacent pin (104);
a short-resistant pad (202) coupled to the short-resistant pin;
an adjacent pad (204) coupled to the adjacent pin;
a short-resistant pin core logic (502) configured to produce a first signal for the short-resistant pin;
an adjacent pin core logic (504) configured to produce a second signal for the adjacent pin; and
short-resistant circuitry (206) coupled to the short-resistant pad and the adjacent pad, the short-resistant circuitry configured to:
detect a short-circuit condition between the short-resistant pin and the adjacent pin; and **characterized by** being further configured to
prevent the second signal from being produced at the adjacent pin in response to the detection of the short-circuit condition.

2. The integrated circuit (500) of claim 1, wherein the short-resistant circuitry (206) comprises:
a short detector (506) configured to detect the short-circuit condition between the short-resistant pin and the adjacent pin; and
an output controller (508) configured to prevent the second signal from being produced at the adjacent pin in response to the detection of the short-circuit condition.

3. The integrated circuit (500) of claim 2, wherein the short detector (506) is further configured to:
monitor a voltage level at the short-resistant pin; and
provide a detection alert indicator to the output controller responsive to the voltage level.

4. The integrated circuit (500) of claim 3, wherein the short detector (506) is further configured to generate the detection alert indicator if the voltage level at the short-resistant pin has an intermediate voltage value that is between a high voltage threshold and a low voltage threshold.

5. The integrated circuit (500) of claim 3, wherein the short detector (506) is further configured to generate the detection alert indicator if the voltage level at the short-resistant pin deviates from an intended voltage level of the first signal by more than a deviation threshold.

6. The integrated circuit (500) of claim 2, wherein the output controller (508) is further configured to:
receive a detection alert indicator from the short detector; and
control a voltage level at the adjacent pin responsive to the detection alert indicator.

7. The integrated circuit (500) of claim 6, wherein the output controller (508) is further configured to control the voltage level at the adjacent pin by de-asserting an output enable terminal of the adjacent pad, or
by causing the adjacent pin to have a voltage value that corresponds to an intended voltage level for the short-resistant pin,
wherein the short-resistant pin core logic is preferably configured to provide the first signal to the output controller, the first signal indicative of the intended voltage level for the short-resistant pin.

8. The integrated circuit (500) of claim 1, wherein:
the short-resistant pin (102) comprises an error pin for the integrated circuit; and
the error pin is configured to output a particular logical value of the first signal if the integrated circuit experiences a fault.

9. The integrated circuit (500) of claim 8, wherein the short-resistant circuitry (206) is further configured to control an output of the adjacent pad to prevent the adjacent pin from substantially impacting a voltage level on the error pin if the short-circuit condition is detected, the voltage level corresponding to the particular logical value.

10. The integrated circuit (500) of claim 1, wherein the integrated circuit comprises part of an Advanced Driver Assistance System, ADAS,.

11. The integrated circuit (500) of claim 1, wherein:
the short-resistant pad (102) comprises a first input/output pad; and
the adjacent pad (204) comprises a second input/output pad.

12. The integrated circuit (500) of claim 1, wherein the short-resistant pin (102) comprises an error pin configured to report an occurrence of a fault that is detected by the integrated circuit in accordance with an Advanced Driver Assistance System, ADAS, application.

13. The integrated circuit (500) of claim 1, further comprising:
a second adjacent pin; and
a second adjacent pad coupled to the second adjacent pin,
wherein the short-resistant circuitry (206) is further coupled to the second adjacent pad, the short-resistant circuitry further configured to detect a second short-circuit condition between the short-resistant pin and the second adjacent pin and to reduce an effect of the second short-circuit condition on the short-resistant pin.

14. A method (100) for implementing short-resistant output pin circuitry, the method comprising:
generating a first signal for a short-resistant pin (102);
generating a second signal for an adjacent pin (104);
monitoring (102) an actual voltage level at the short-resistant pin;
determining (1004) if the actual voltage level deviates from an intended voltage level of the first signal; **characterized by**
controlling (1006) whether to output the second signal to the adjacent pin based on the determining.

## Patentansprüche

1. Ein integrierter Schaltkreis (500), der Folgendes aufweist:
einen kurzschlussbeständigen Pin (102);
einen benachbarten Pin (104);
ein kurzschlussbeständiges Pad (202), das an den kurzschlussbeständigen Pin gekoppelt ist;
ein benachbartes Pad (204), das an den benachbarten Pin gekoppelt ist;
eine Core- bzw. Kernlogik (502) des kurzschlussbeständigen Pins, die konfiguriert ist zum Erzeugen eines ersten Signals für den kurzschlussbeständigen Pin;
eine Core- bzw. Kernlogik (504) des benachbarten Pins, die konfiguriert ist zum Erzeugen eines zweiten Signals für den benachbarten Pin; und
eine kurzschlussbeständige Schaltung (206), die an das kurzschlussbeständige Pad und das benachbarte Pad gekoppelt ist, wobei die kurzschlussbeständige Schaltung konfiguriert ist zum:
Detektieren eines Kurzschlusszustandes zwischen dem kurzschlussbeständigen Pin und dem benachbarten Pin; und die **dadurch gekennzeichnet ist, dass** sie weiter konfiguriert ist zum
Verhindern, dass das zweite Signal an dem benachbarten Pin erzeugt wird ansprechend auf die Detektion des Kurzschlusszustandes.

2. Integrierter Schaltkreis (500) nach Anspruch 1, wobei die kurzschlussbeständige Schaltung (206) Folgendes aufweist:
einen Kurzschlussdetektor (506), der konfiguriert ist zum Detektieren des Kurzschlusszustandes zwischen dem kurzschlussbeständigen Pin und dem benachbarten Pin; und
einen Ausgabecontroller (508), der konfiguriert ist zum Verhindern, dass das zweite Signal an dem benachbarten Pin erzeugt wird ansprechend auf die Detektion des Kurzschlusszustandes.

3. Integrierter Schaltkreis (500) nach Anspruch 2, wobei der Kurzschlussdetektor (506) weiter konfiguriert ist zum:
Überwachen eines Spannungspegels an dem kurzschlussbeständigen Pin; und
Vorsehen eines Detektionswarnungsindikators an den Ausgabecontroller ansprechend auf den Spannungspegel.

4. Integrierter Schaltkreis (500) nach Anspruch 3, wobei der Kurzschlussdetektor (506) weiter konfiguriert ist zum Generieren des Detektionswarnungsindikators, wenn der Spannungspegel an dem kurzschlussbeständigen Pin einen mittleren Spannungswert hat, der zwischen einem hohen Spannungsschwellenwert und einem niedrigen Spannungsschwellenwert ist.

5. Integrierter Schaltkreis (500) nach Anspruch 3, wobei der Kurzschlussdetektor (506) weiter konfiguriert ist zum Generieren des Detektionswarnungsindikators, wenn der Spannungspegel an dem kurzschlussbeständigen Pin von einem beabsichtigten Spannungspegel des ersten Signals um mehr als einen Abweichungsschwellenwert abweicht.

6. Integrierter Schaltkreis (500) nach Anspruch 2, wobei der Ausgabecontroller (508) weiter konfiguriert ist zum:
Empfangen eines Detektionswarnungsindikators von dem Kurzschlussdetektor; und
Steuern eines Spannungspegels an dem benachbarten Pin ansprechend auf den Detektionswarnungsindikator.

7. Integrierter Schaltkreis (500) nach Anspruch 6, wobei der Ausgabecontroller (508) weiter konfiguriert ist zum Steuern des Spannungspegels an dem benachbarten Pin durch Nicht-Länger-Setzen eines Ausgabeaktivierungsanschlusses des benachbarten Pads, oder
durch Veranlassen des benachbarten Pins einen Spannungswert zu haben, der einem beabsichtigten Spannungspegel für den kurzschlussbeständigen Pin entspricht,
wobei die Kern- bzw. Core-Logik des kurzschlussbeständigen Pins vorzugsweise konfiguriert ist zum Vorsehen des ersten Signals an den Ausgabecontroller, wobei das erste Signal den beabsichtigten Spannungspegel für den kurzschlussbeständigen Pin anzeigt.

8. Integrierter Schaltkreis (500) nach Anspruch 1, wobei:
der kurzschlussbeständige Pin (102) einen Fehler-Pin für den integrierten Schaltkreis aufweist; und
der Fehler-Pin konfiguriert ist zum Ausgeben eines bestimmten logischen Wertes des ersten Signals, wenn der integrierter Schaltkreis einen Fehler erfährt.

9. Integrierter Schaltkreis (500) nach Anspruch 8, wobei die kurzschlussbeständige Schaltung (206) weiter konfiguriert ist zum Steuern einer Ausgabe des benachbarten Pads um zu verhindern, dass der benachbarte Pin einen Spannungspegel des Fehler-Pins wesentlich beeinflusst, wenn der Kurzschlusszustand detektiert wird, wobei der Spannungspegel dem bestimmten logischen Wert entspricht.

10. Integrierter Schaltkreis (500) nach Anspruch 1, wobei der integrierte Schaltkreis ein ADAS (ADAS = Advanced Driver Assistance System bzw. erweitertes Fahrerunterstützungssystem) aufweist.

11. Integrierter Schaltkreis (500) nach Anspruch 1, wobei:
das kurzschlussbeständige Pad (102) ein erstes Eingabe/Ausgabe-Pad aufweist; und
das benachbarte Pad (204) ein zweites Eingabe/Ausgabe-Pad aufweist.

12. Integrierter Schaltkreis (500) nach Anspruch 1, wobei der kurzschlussbeständige Pin (102) einen Fehler-Pin aufweist, der konfiguriert ist zum Berichten eines Auftretens eines Fehlers, der durch den integrierten Schaltkreis detektiert wird, und zwar gemäß einer ADAS-Anwendung.

13. Integrierter Schaltkreis (500) nach Anspruch 1, der weiter Folgendes aufweist:
einen zweiten benachbarten Pin; und
ein zweites benachbartes Pad, das an den zweiten benachbarten Pin gekoppelt ist,
wobei die kurzschlussbeständige Schaltung (206) weiter an das zweite benachbarte Pad gekoppelt ist, wobei die kurzschlussbeständige Schaltung weiter konfiguriert ist zum Detektieren eines zweiten Kurzschlusszustandes zwischen dem kurzschlussbeständigen Pin und dem zweiten benachbarten Pin und zum Verringern eines Effekts des zweiten Kurzschlusszustandes auf den kurzschlussbeständigen Pin.

14. Ein Verfahren (100) zum Implementieren eines Schaltkreises für einen kurzschlussbeständigen Ausgabe-Pin, wobei das Verfahren Folgendes aufweist:
Generieren eines ersten Signals für einen kurzschlussbeständigen Pin (102);
Generieren eines zweiten Signals für einen benachbarten Pin (104);
Überwachen (102) eines tatsächlichen Spannungspegels an dem kurzschlussbeständigen Pin;
Bestimmen (1004), ob der tatsächliche Spannungspegel von einem beabsichtigten Spannungspegel des ersten Signals abweicht; **gekennzeichnet durch**
Steuern (1006), ob das zweite Signal an den benachbarten Pin ausgegeben werden soll, basierend auf der Bestimmung.

## Revendications

1. Circuit intégré (500) comprenant :
une broche résistante aux courts-circuits (102) ;
une broche adjacente (104) ;
un plot résistant aux courts-circuits (202) couplé à la broche résistante aux courts-circuits ;
un plot adjacent (204) couplé à la broche adjacente ;
des circuits logiques internes de la broche résistante aux courts-circuits (502) configurés pour produire un premier signal pour la broche résistante aux courts-circuits ;
des circuits logiques internes de la broche adjacente (504) configurés pour produire un deuxième signal pour la broche adjacente ; et
un circuit résistant aux courts-circuits (206) couplé au plot résistant aux courts-circuits et au plot adjacent, le circuit résistant aux courts-circuits étant configuré pour :
détecter une condition de court-circuit entre la broche résistante aux courts-circuits et la broche adjacente ; et
**caractérisé en ce qu'**il est en outre configuré pour éviter que le deuxième signal ne soit produit au niveau de la broche adjacente en réponse à la détection de la condition de court-circuit.

2. Circuit intégré (500) selon la revendication 1, dans lequel le circuit résistant aux courts-circuits (206) comprend :
un détecteur de court-circuit (506) configuré pour détecter la condition de court-circuit entre la broche résistante aux courts-circuits et la broche adjacente ; et
un contrôleur de sortie (508) configuré pour éviter que le deuxième signal ne soit produit au niveau de la broche adjacente en réponse à la détection de la condition de court-circuit.

3. Circuit intégré (500) selon la revendication 2, dans lequel le détecteur de court-circuit (506) est en outre configuré pour :
surveiller un niveau de tension au niveau de la sortie de la broche résistante aux courts-circuits ; et
fournir un indicateur d'alerte de détection au contrôleur de sortie en réponse au niveau de tension.

4. Circuit intégré (500) selon la revendication 3, dans lequel le détecteur de court-circuit (506) est en outre configuré pour générer l'indicateur d'alerte de détection si le niveau de tension au niveau de la broche résistante aux courts-circuits a une valeur de tension intermédiaire comprise entre un seuil de haute tension et un seuil de basse tension.

5. Circuit intégré (500) selon la revendication 3, dans lequel le détecteur de court-circuit (506) est en outre configuré pour générer l'indicateur d'alerte de détection si le niveau de tension au niveau de la broche résistante aux courts-circuits s'écarte du niveau de tension souhaité du premier signal de plus d'un seuil d'écart.

6. Circuit intégré (500) selon la revendication 2, dans lequel le contrôleur de sortie (508) est en outre configuré pour :
recevoir un indicateur d'alerte de détection provenant du détecteur de court-circuit ; et
piloter un niveau de tension au niveau de la broche adjacente en réponse à l'indicateur d'alerte de détection.

7. Circuit intégré (500) selon la revendication 6, dans lequel le contrôleur de sortie (508) est en outre configuré pour piloter le niveau de tension au niveau de la broche adjacente en désaffectant une borne d'activation de sortie du plot adjacent, ou
en forçant la broche adjacente à avoir une valeur de tension qui correspond à un niveau de tension souhaité pour la broche résistante aux courts-circuits,
dans lequel les circuits logiques internes de la broche résistante aux courts-circuits sont configurés pour fournir le premier signal au contrôleur de sortie, le premier signal étant indicatif du niveau de tension souhaité pour la broche résistante aux courts-circuits.

8. Circuit intégré (500) selon la revendication 1, dans lequel :
la broche résistante aux courts-circuits (102) comprend une broche d'erreur pour le circuit intégré ; et
la broche d'erreur est configurée pour fournir une valeur logique particulière du premier signal si le circuit intégré rencontre un défaut.

9. Circuit intégré (500) selon la revendication 8, dans lequel le circuit résistant aux courts-circuits (206) est en outre configuré pour piloter une sortie du plot adjacent pour éviter que la broche adjacente n'influence sensiblement un niveau de tension sur la broche d'erreur si la condition de court-circuit est détectée, le niveau de tension correspondant à la valeur logique particulière.

10. Circuit intégré (500) selon la revendication 1, dans lequel le circuit intégré comprend une partie d'un système d'assistance au conducteur avancé, ADAS.

11. Circuit intégré (500) selon la revendication 1, dans lequel :
le plot résistant aux courts-circuits (102) comprend un premier plot d'entrée/sortie ; et
le plot adjacent (204) comprend un deuxième plot d'entrée/sortie.

12. Circuit intégré (500) selon la revendication 1, dans lequel la broche résistante aux courts-circuits (102) comprend une broche d'erreur configurée pour signaler l'occurrence d'un défaut qui est détecté par le circuit intégré conformément à une application d'un système d'assistance au conducteur avancé, ADAS.

13. Circuit intégré (500) selon la revendication 1, comprenant en outre :
une deuxième broche adjacente ; et
un deuxième plot adjacent couplé à la deuxième broche adjacente,
dans lequel le circuit résistant aux courts-circuits (206) est en outre couplé au deuxième plot adjacent, le circuit résistant aux courts-circuits étant en outre configuré pour détecter une deuxième condition de court-circuit entre la broche résistante aux courts-circuits et la deuxième broche adjacente et pour réduire un effet de la deuxième condition de court-circuit sur la broche résistante aux courts-circuits.

14. Procédé (100) de réalisation d'un circuit de broche de sortie résistante aux courts-circuits, le procédé comprenant les étapes suivantes :
la génération d'un premier signal pour une broche résistante aux courts-circuits (102) ;
la génération d'un deuxième signal pour une broche adjacente (104) ;
la surveillance (102) d'un niveau de tension réel au niveau de la broche résistante aux courts-circuits ;
la détermination (1004) de si le niveau de tension réel s'écarte d'un niveau de tension souhaité du premier signal ; **caractérisé par**
la commande (1006) de si doit être fourni le deuxième signal à la broche adjacente sur la base de la détermination.
